(19) Europäisches Patentamt
European Patent Office
Office européen des brevets

(11) **EP 1 478 064 A1**

(12) **EUROPEAN PATENT APPLICATION**

(43) Date of publication:
**17.11.2004 Bulletin 2004/47**

(51) Int Cl.⁷: **H01S 5/0625**, H01S 5/12

(21) Application number: **03258261.1**

(22) Date of filing: **31.12.2003**

(84) Designated Contracting States:
**AT BE BG CH CY CZ DE DK EE ES FI FR GB GR
HU IE IT LI LU MC NL PT RO SE SI SK TR**
Designated Extension States:
**AL LT LV MK**

(30) Priority: **15.05.2003 KR 2003030777**

(71) Applicant: **Electronics and Telecommunications
Research Institute
Daejon-city 305-350 (KR)**

(72) Inventors:
• **Park, Moon-Ho
Daejon 305-707 (KR)**
• **Lee, Chul-Wook
Yuseong-gu Daejon 305-751 (KR)**
• **Ko, Hyun-Sung
Daejon 302-831 (KR)**

• **Chung, Youngchul
Nowon-gu Seoul 139-221 (KR)**
• **Oh, Su-Hwan
Yuseong-gu Daejon 305-756 (KR)**
• **Lee, Ji-Myon
Suncheon-si Jeollanam-do (KR)**
• **Kim, Kisoo
Jeollabuk-do 560-033 (KR)**
• **Park, Sahnggi
Daejon 302-773 (KR)**
• **Kim, Su-hyun
Eunpyeong-gu Seoul 122-806 (KR)**

(74) Representative: **Powell, Timothy John
Eric Potter Clarkson,
Park View House,
58 The Ropewalk
Nottingham NG1 5DD (GB)**

(54) **Widely tunable sampled-grating distributed feedback laser diode**

(57) The sampled-grating, distributed-feedback laser diode of the present invention has a high output optical efficiency in comparison with a conventional wavelength tunable laser provided with Bragg reflection ends at both ends of the gain region for wavelength tuning as a structure capable of connecting an optical fiber directly without losing the optical wave generated at the gain region. And also, the present invention can be manufactured by the manufacturing process of a conventional wavelength tunable laser diode without reinvesting a new equipment. Further, the SG-DFB laser diode of the present invention can control a broadband wavelength with a simple circuit construction in comparison with a conventional wavelength tunable laser diode since it can vary the wavelength continuously or discontinuously by the change of current of each region of the phase control regions.

FIG. 3

A FIRST REGION
(A FIRST SG-DFB STRUCTURE MEMBER)

A SECOND REGION
(A SECOND SG-DFB STRUCTURE MEMBER)

EP 1 478 064 A1

Printed by Jouve, 75001 PARIS (FR)

## Description

Field of the Invention

The present invention relates to a semiconductor laser diode; and, more particularly to a sampled-grating distributed feedback laser diode capable of tuning a wavelength of a light beam generated therefrom widely by using the characteristics of sampled-grating.

Description of Related Art

With a drastic increase of the amount of information transmitted through a communication, an optical signal transmission using a wavelength division multiplexing method is widely used for increasing the amount of information transmission. The method transmits optical signals at different wavelengths (channels) through an optical fiber by using incoherence between optical waves having a color different from each other, thereby increasing the transmission capacity. The optical signal transmission using the wavelength division multiplexing method has an advantage of securing the extendibility and flexibility of an optical communication system. In order to transmit the optical signal transmission of the wavelength division multiplexing method, a laser diode should have a fixed wavelength belonging to ITU wavelength grids or a laser diode is required to exhibit wavelength tuning characteristics.

A wavelength tunable laser diode has various advantages of reducing the number of backup light sources to maintain and repair the system as well as to supply the wavelength dynamically, and simplifying the network control software. In this result, the wavelength tunable laser diode has been recognized as a necessary device in all application fields from a subscriber network to a long distance network.

The wavelength tunable laser diode is required to have a high power, i.e., being larger than 10 mW, to be tunable to all wavelengths larger than 32 nm of C-band, to exhibit a rapid wavelength tuning, i.e., faster than 10 ns, to perform a high speed direct modulation, i.e., faster than 2.5 Gbps and to be produced in commercial quantity.

Typical wavelength tunable laser diodes developed or proposed up to now are a sampled-grating distribution Bragg reflector SG-DBR laser diode, a super-structure grating distributed Bragg reflector SSG-DBR laser diode, a grating-assisted co-directional coupler with sampled grating reflector GCSR or the like.

With reference to the accompanying drawings, various conventional wavelength tunable laser diodes are described hereinafter.

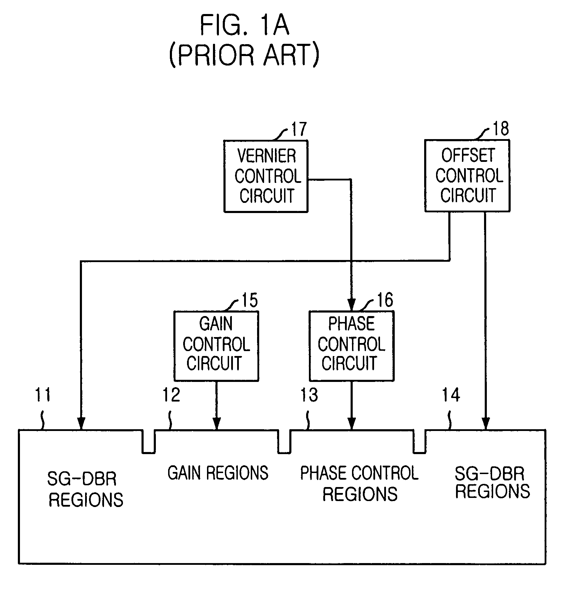

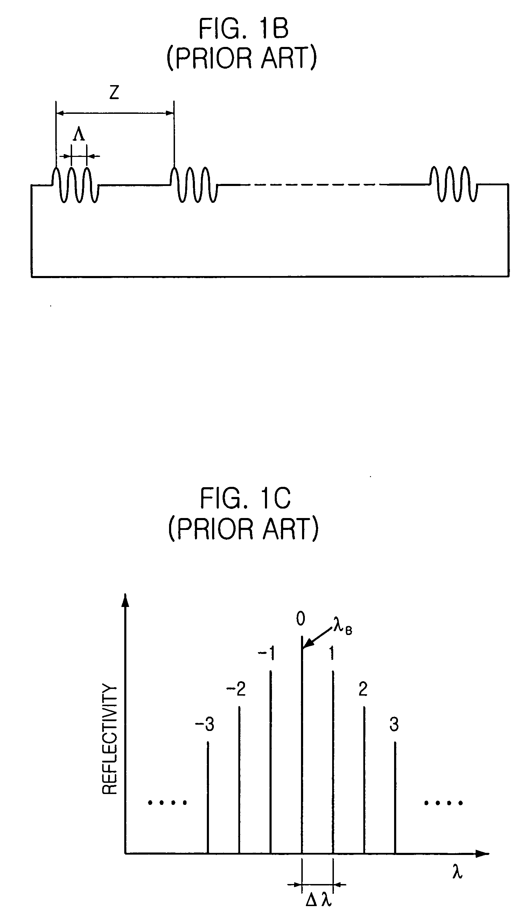

Figs. 1A and 1B are a schematic block diagram illustrating a structure and a control circuit of a sampled-grating distribution reflection semiconductor laser diode SG-DBR described in U.S. patent 4,896,325.

As shown in Fig. 1A, the SG-DBR laser diode consists of 4 regions, i.e., a pair of SB-DBR regions 11, 14 at both ends of the laser diode for tuning an optical wave emitted from the SG-DBR laser diode, a gain region 12 for generating the optical wave and a phase control region 13. And, in order to vary the wavelength of the laser emitted from the SG-DBR laser diode, external control circuits such as a Vernier control circuit 17 for a continuous wavelength tuning, an offset control circuit 18 for a discontinuous wavelength movement, a phase control circuit 16 of the phase control region 13 and a gain control circuit 15 or the like are required.

The basic operation principle of the SG-DBR laser diode is as follows. If a current is applied to the gain region 12, the laser diode oscillates at a specific wavelength at which the reflection peaks of two SG-DBR are aligned.

In the SG-DBR region shown in Fig. 1A, the sampled-grating structure is formed as shown in Fig. 1B. The reflection spectrum of the SG-DBR is shown in Fig. 1C. The wavelength of the central peak in the reflection spectrum is Bragg wavelength ($\lambda_B$) determined by the diffraction grating period ($\Lambda$) and the distance between the wavelengths corresponding to the adjacent peaks is determined by the period (Z) of the sampled-grating. That is, the laser diode oscillates at the wavelength corresponding to one selected from the peaks of the reflection spectrums in the SG-DBR regions 11, 14 by integrating the SG-DBR regions 11, 14 having a period different from each other on the both ends.

And, each of the peaks of the reflection spectrum is moved with maintaining the distance between the wavelengths by changing the refractive index of the SG-DBR regions 11, 14 by a current or the like. The lasing wavelength can be tuned by varying the wavelength at which the reflection peaks from the two SG-DBR's are aligned by the movement of the reflection peaks. The phase control region 13 can vary the wavelength continuously by controlling the longitudinal mode spacing of the gain region 12 generated by the SG-DBR or play a role in maximizing the power by aligning the longitudinal mode to the reflection peak. By this principle, the continuous/discontinuous wavelength tuning is obtained by appropriately controlling the refractive index of the SG-DBR regions 11, 14 and the phase control region 13 by the current.

However, in such an SG-DBR laser diode, there is a structural limit that the external circuit becomes complex to control this device and the optical efficiency of the output is reduced by the loss generated in the SG-DBR.

In order to overcome the above-described problems, however, integrating a semiconductor optical amplifier SOA onto the laser diode has been actively developed.

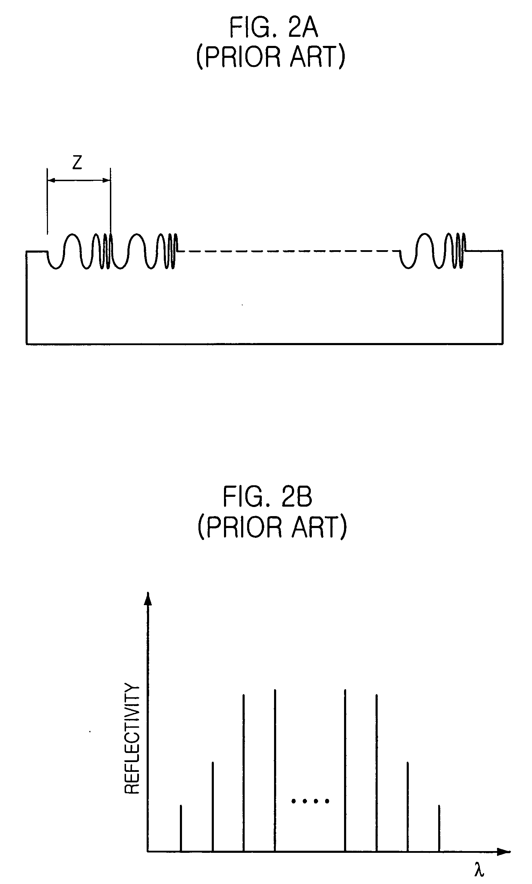

Fig. 2A is a concept diagram illustrating a super - structure grating distributed Bragg reflector SSG-DBR laser diode in which the grating period is periodically modulated, hence making it possible to tune the wavelength. Fig. 2B is a schematic diagram representing the reflection spectrum by the diffraction grating shown in Fig. 2A. Hereinafter, another typical SSG-DBR laser diode as a wavelength tuning laser diode is described with reference to Fig. 2A and Fig. 2B.

The SSG-DBR laser diode is disclosed in U.S. Patent 5,325,392. Basically, the SSG-DBR laser diode is operated similarly to the SG-DBR shown in Figs. 1A, 1B and 1C in structure and principle. That is, the SSG-DBR regions take the place of the SG-DBR region shown in Figs. 1A, 1B and 1C.

As shown in Fig. 2A, the period of the reflection grating provided for tuning the wavelength is periodically modulated in space. By the spatial modulation of the grating, the reflection spectrum has the characteristics shown in Fig. 2B. The distance between the adjacent reflection peaks is determined by the period (Z) and the size of each of the reflection peaks is determined by the spatial modulation of the diffraction grating.

However, although the SSG-DBR laser diode shows a wide wavelength tuning and emits a relatively constant output power in response to the variation of the wavelength, the SSG-DBR laser diode generates a loss in the SSG-DBR regions similarly to the SG-DBR laser diode and exhibits a number of problems having a number of difficulties in manufacturing due to the complex diffraction grating structure.

The conventional wavelength tunable laser diodes except for the above-described wavelength tunable laser diodes are GCSR laser diode and a wavelength tunable twin-guide laser diode or the like. But, such kinds of laser diodes have a shortcoming in manufacturing and mass production since a number of regrowths and etchings are involved in manufacturing the laser diode.

Accordingly, the conventional wavelength tunable laser diodes have a number of points to be improved in terms of simple fabrication, emission efficiency of the output thereof or simple wavelength tuning control.

Summary of the Invention

It is, therefore, an object of the present invention to provide a SG-DFB laser diode having a high output optical efficiency in comparison with the conventional wavelength tunable lasers provided with Bragg reflection ends at the both ends of the gain region for the wavelength tuning as a structure capable of connecting an optical fiber directly without losing the optical wave generated at the gain region, controlling a broad band wavelength (larger than 30 nm) with a simple circuit construction and being manufactured by the manufacturing process of a conventional wavelength tunable laser diode without reinvesting a new equipment.

In accordance with an aspect of the present invention, there is provided a tunable sampled-grating distributed feedback laser diode provided with a first gain region and a second gain region adjacent to each other, including: a first SG-DFB structure member formed thereon a first phase control region between first sampled-gratings and the first sampled-gratings having a first period formed on the first gain region; and a second SG-DFB structure member formed thereon a second phase control region between second sampled-gratings and the second sampled-gratings having a second period formed on the second gain region, wherein the tunable sampled-grating distributed feedback laser diode tunes the wavelength of laser generated in response to a reflection change of the first and the second phase control regions.

In accordance with another aspect of the present invention, there is provided a tunable sampled-grating distributed feedback laser diode for tuning a wavelength of an oscillating laser, including: a substrate provided with a first region and a second region adjacent to each other; a wave guide layer formed on the first region and the second region of the substrate; a multiple quantum well active layer formed in the wave guide layer by a predetermined distance for providing a plurality of phase control regions; a first sampled-grating region having a first period and the phase control region formed between the sampled-grating; a second sampled-grating region having a second period and the phase control region formed between the sampled-grating; a clad layer formed on the wave guide layer; a first phase control electrode formed on the clad layer of the first region for supplying a current to the phase control region of the first region; a second phase control electrode formed on the clad layer of the second region for supplying a current to the phase control region of the second region; a first gain region electrode formed on the clad layer of the first region for supplying a current to the wave guide layer except the phase control region of the first region; and a second gain region electrode formed on the clad layer of the second region for supplying a current to the wave guide layer except the phase control region of the second region.

The wavelength of oscillating laser can be vary continuously or incontinuously by changing the reflective index of the phase control region formed between the sampled-grating of the first period and the sampled-grating of the second period in the SG-DFB laser diode formed as described above. In this time, the substrate is an n type InP substrate, the wave guide layer is a material such as InGaAsP and the upper clad layer is a p type InP.

Preferably, the phase control regions provided in the sampled-grating of the first period and the sampled-grating of the second period are constructed in such a way that the reflective index can be changed by the application of the current. And also, an optical modulator or a semiconductor optical amplifier together with the tunable sampled-grating distributed feedback laser diode as described above is integrated into a semiconductor substrate for serving as an optical communication device.

## Brief Description of the Drawings

The above and other objects and features of the present invention will become apparent from the following description of the preferred embodiments given in conjunction with the accompanying drawings, in which:

Fig. 1A is a schematic block diagram illustrating a sampled-grating distribution reflection semiconductor laser diode according to a prior art;

Fig. 1B is a concept view showing the diffraction grating provided in the sampled-grating distribution Bragg reflection (SG-DBR) region of the laser diode shown in Fig. 1A;

Fig. 1C is a schematic diagram describing a reflection spectrum of the SG-DBR region in the laser diode shown in Fig. 1A;

Fig. 2A is a concept diagram illustrating a diffraction grating of Bragg reflection portion modulated in grating period according to another prior art;

Fig. 2B is a schematic diagram representing the reflection spectrum by the diffraction grating shown in Fig. 2A;

Fig. 3 is a cross-sectional view showing a widely tunable sampled-grating distributed feedback laser diode in accordance with a first preferred embodiment of the present invention;

Fig. 4A is a concept view illustrating a diffraction grating of a conventional distributed feedback laser diode;

Fig. 4B is a schematic diagram representing the reflection spectrum by the diffraction grating of the widely tunable sampled-grating distributed feedback laser diode shown in Fig. 4A;

Fig. 5A is a concept view describing each of the regions when the reflective indexes of the phase control regions at a first region and a second region are not changed in the widely tunable sampled-grating distributed feedback laser diode shown in Fig. 3;

Fig. 5B is a concept view describing each of the regions when one of the reflective indexes of the phase control regions at a first region and a second region is changed in the widely tunable sampled-grating distributed feedback laser diode shown in Fig. 3;

Fig. 5C is a concept view describing each of the regions when the reflective index of the first region of the phase control region is changed equal to that of the second region of the phase control region in the widely tunable sampled-grating distributed feedback laser diode shown in Fig. 3;

Fig. 6 is a graph showing the change of oscillation wavelength when the reflective indexes of the first region and the second region of the phase control region in the widely tunable sampled-grating distributed feedback laser diode shown in Fig. 3 through a computer simulation;

Fig. 7 is a perspective view illustrating the widely tunable sampled-grating distributed feedback laser diode shown in Fig. 3; and

Fig. 8 is a cross-sectional view describing the widely tunable sampled-grating distributed feedback laser diode in accordance a second preferred embodiment of the present invention.

## Detailed Description of the Invention

A preferred embodiment of the present invention will now be described with reference to the accompanying drawings so as to easily embody the principle of the present invention and to easily invent various apparatus within the scope and concept of the present invention from the description by the those skilled in the art.

Following description only exemplifies the principle of the present invention. Although the description of the principle may not be clear or all possible embodiments of the present invention is not illustrated in the specification, those skilled in the art can embody the principle of the present invention and invent various apparatus within the scope and concept of the present invention from the description. Also, all the conditional terms and embodiments described in the specification are intended to make the concept of this invention understood, in principle, and the present invention should be understood not limited to the described embodiments or conditions only.

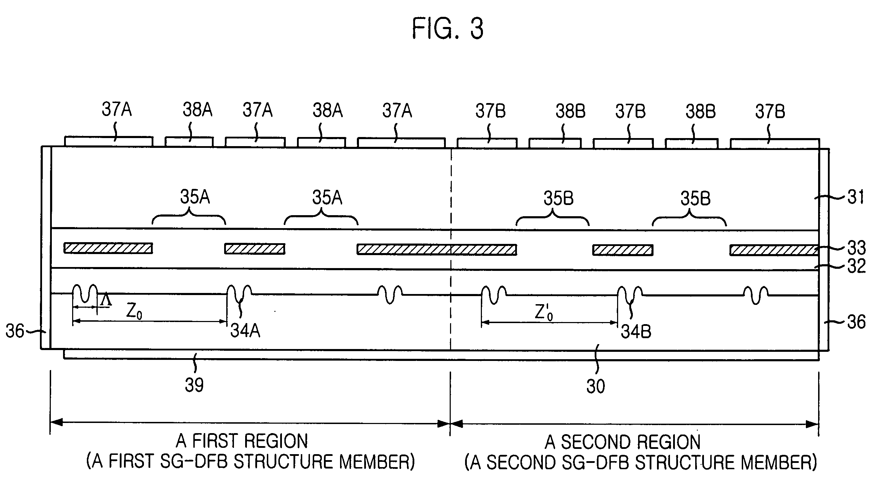

Fig. 3 is a schematic cross-sectional view showing a widely tunable sampled-grating distributed feedback (SG-DFB) laser diode capable of tuning the wavelength of the laser oscillated in accordance with a first preferred embodiment of the present invention.

Referring to Fig. 3, the major characteristics of the SG-DFB wavelength tunable laser diode in accordance with a present invention are as follows: a first and a second phase control regions 35A, 35B are inserted into each of a first and a second active regions; and a first sampled-grating 34A having a first period (Z0) and a second sampled-grating 34B having a second period (Z'0) are integrated on a pair of different two regions, i. e., of the first region and the second region (a first and a second SG-DFB structure members).

In accordance with the preferred embodiment of the present invention, the SG-DFB laser diode continuously/incontinuously tunes the wavelength of the laser emitted from the SG-DFB laser diode in a wide region (above 30 nm) by changing the reflective index of the phase control regions 35A, 35B provided.

The first region (the first SG-DFB structure member) includes a first sampled-grating 34A having the first period (Z0) formed on a n type InP substrate 30 serving as a lower clad layer; an InGaAsP wave guide layer 32 formed on top of the first sampled-grating 34A;

a first phase control region 35A formed inside of the In-GaAsP wave guide layer 32 and an active layer 33 capable of becoming a multiple quantum well structure; and a gain region formed in the InGaAsP wave guide layer 32. And, a p type InP clad layer 31 is formed on top of the InGaAsP wave-guide layer 32 as an upper clad layer. A plurality of electrodes are formed on the p type InP clad layer 31, i.e., a first phase control electrode 38A is formed on top of the first phase control region 35A and an electrode 37A of the first gain region is formed on top of the active layer 33 serving as a gain region.

And also, an n type electrode 39 is formed on the bottom of the n type InP clad layer 30 and an anti-reflection thin film 36 is formed on both ends of the semiconductor laser diode.

On the other hand, the second region (the second SG-DFB) has a structure similar to those of the first region excepting that the second phase control region 35B. The second phase control region 35B is formed between active layers 33 capable of the multiple quantum well structure.

And, the second period (Z'0) of the second sampled-grating 34B formed on the bottom of the second region of the active layer 33 is differently formed comparing to the first period (Z0) of the first sampled-grating 34a formed on the bottom of the first region of the active layer 33. Also, the diffraction period ($\Lambda$) of the first sampled-grating 34A is formed identically comparing to that of the second sampled-grating 34B.

Here, the gain region of the active layer 33 of the first region and the second region and the phase control regions 35A, 35b can be made of a material such as InGaAsP, and the band gaps in the two regions 34A, 34B are different from each other. For example, the active layer 33 as the gain region of the first and the second regions 34A, 34B can be made of InGaAsP having 1.55 μm band gap wavelength. The phase control regions 35A, 35B can be made of a material InGaAsP having 1.3 μm band gap wavelength.

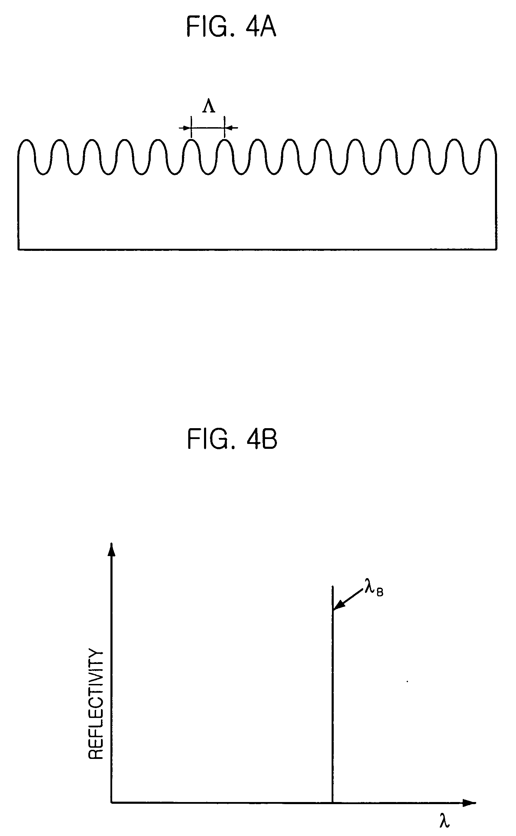

Fig. 4A is a concept view illustrating a diffraction grating of a conventional distributed feedback DFB laser diode and Fig. 4B is a graph representing the reflection spectrum by the diffraction grating of the widely tunable sampled-grating distributed feedback laser diode shown in Fig. 4A. At first, the operation of the DFB laser diode is described hereinafter with reference to Fig. 4A and Fig. 4B.

The gain region of the semiconductor laser generates an optical wave by a spontaneous emission caused by a current applied from outside. The optical wave has an energy distributed over a wide wavelength region with respect to a specific wavelength determined by the characteristics of the medium of the laser diode as a central wavelength. In order to generate an optical wave having energy concentrated to a specific wavelength, the stimulated emission is required to use for generating the optical wave. The stimulated emission is generated by the optical wave generated by the spontaneous emission and the optical wave generated by the stimulated emission is generated by the oscillation in the cavity of the laser diode.

The condition of the oscillation is determined by the characteristics of the effective reflective index of the laser diode. That is, the laser diode is oscillated at a wavelength having the highest effective reflective index and the laser diode is also oscillated in single mode when there is large difference between an effective reflective index of the laser diode and an effective reflective index of the wavelength of neighboring modes.

Meanwhile, the DFB semiconductor laser diode has a structure provided with a diffraction grating having a constant pitch ($\Lambda$) in the gain region as shown in Fig. 4A. A reflection spectrum of the diffraction grating has a large reflective index at the Bragg wavelength ($\lambda_B$) as shown in Fig. 4B.

And also, if an anti-reflection coating layer is formed on the both ends of the region for generating the oscillation in the laser diode, the reflection generates only at the diffraction grating, and the laser beam oscillates in the adjacent of the Bragg wavelength since the effective reflection efficiency is the highest at the Brag wavelength. Here, the Bragg wavelength ($\lambda_B$) can be obtained from the following equation:

$$\lambda_B = 2ng \times \Lambda \qquad \text{Eq. (1)}$$

Wherein ng is a group of reflective index and $\Lambda$ is a diffraction grating. Referring to Eq. (1), the oscillation wavelength of the DFB laser diode is determined by the pitch period ($\Lambda$) of the diffraction grating.

On the other hand, the SG-DFB laser diode utilizes the sampled-grating formed a diffraction grating by a constant period as shown in Fig. 4a. When the structure of the diffraction grating inside of the cavity becomes the sampled-grating as shown in Fig. 3, the laser beams are oscillated at adjacent portions of the reflection peaks. Accordingly, the laser diode can be oscillate as a multi-mode laser, the distance between each of the modes generated by the sampled-grating equals to the period between the peaks of the reflection spectrums and can be calculated by the following equation:

$$\Delta\lambda = \lambda_B{}^2 / (2ng \times Z) \qquad \text{Eq. (2)}$$

Wherein $n_g$ represents a group of reflective index and Z represents a period of sampled-grating. The reflective index of the phase control regions is changed by inserting the phase control region between the sampled-grating of the SG-DFB regions constructed as described above and by controlling the amount of the current applied to the phase control regions from the outside, thereby changing the phase of the optical wave passing through the phase control regions. The changes of the phases play the role of moving the reflection peak, thereby moving the oscillation mode.

In the present invention, the laser diode is integrated with a first SG-DFB and a second SG-DFB structure members which have different a period of the sampled-grating for oscillating the SG-DFB laser diode having the phase control region into a single mode. The sampled-grating period of the laser diode of the present invention can be controlled by a conventional photolithography method since the sampled-grating period of the designed laser diode is larger than several tens $\mu$m.

The first and the second sampled-gratings 34A and 34B formed on the first and the second SG-DFB structure members can be manufactured by a conventional manufacturing method since the periods ($\Lambda$) of the diffraction gratings are equal to each other.

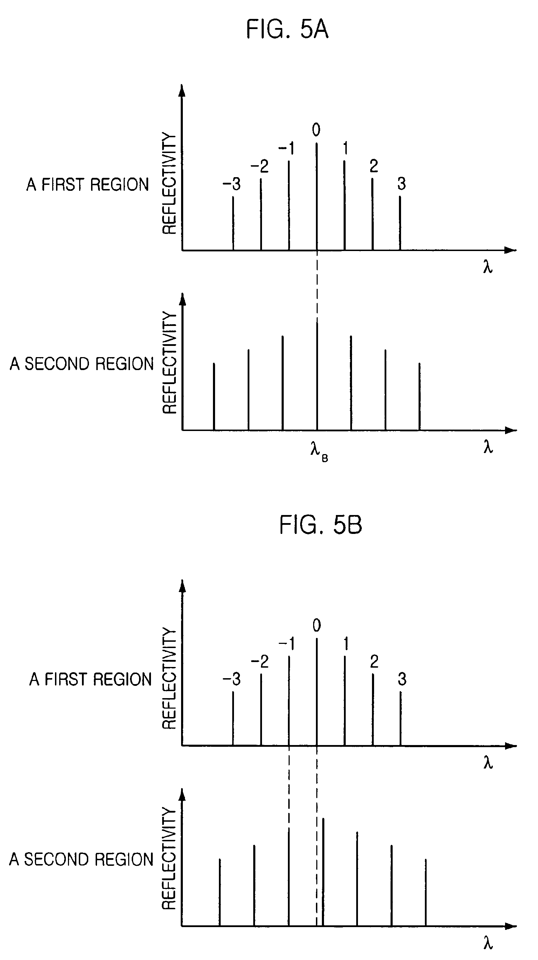

Fig. 5A is a concept view describing each of the regions when the reflective indexes of the phase control regions 38A, 38B at a first region and a second region are not changed in the widely tunable sampled-grating distributed feedback laser diode shown in Fig. 3.

Fig. 5B is a concept view describing each of the regions when one of the reflective indexes of the phase control regions 38A, 38B at a first region and a second region is changed in the widely tunable sampled-grating distributed feedback laser diode shown in Fig. 3.

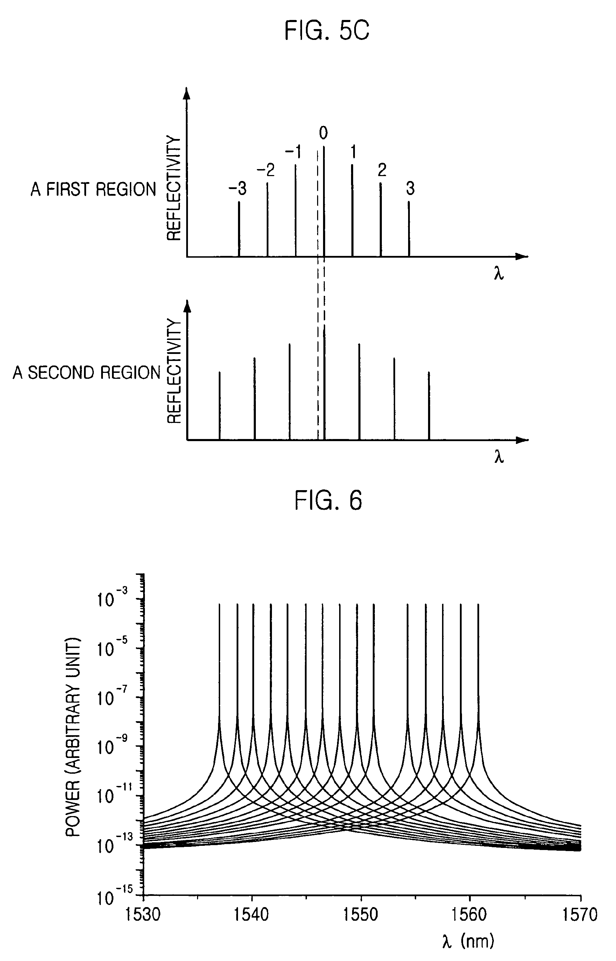

Fig. 5C is a concept view describing each of the regions when the reflective index of the first region 38a of the phase control regions 38A, 38B is changed equal to that of the second region 38B of the phase control regions 38A, 38B in the widely tunable sampled-grating distributed feedback laser diode shown in Fig. 3.

The wavelength tuning principle of the laser diode in accordance with the preferred embodiment of the present invention is described as follows with reference to Fig. 3, Fig. 5A to Fig. 5C.

Referring to Fig. 5A, since the periods($\Lambda$) of the diffraction gratings of the first SG-DFB structure member and the second SG-DFB structure member of the laser diode shown in Fig. 3 are equal to each other and the periods ($Z_0$, $Z'_0$) of sampled-grating are different from each other, the reflection peaks of the first SG-DFB structure member and the second SG-DFB structure member are matched only at the Bragg wavelength ($\lambda_B$). That is, if the laser diode is operated at this status, the laser diode is oscillated at the Bragg wavelength ($\lambda_B$) in a single mode since the laser emitted from the laser diode has the highest effective reflective index at the Bragg wavelength ($\lambda_B$).

And then, referring to Fig. 5B, when the reflective index of the phase control region 35B provided in the second SG-DFB structure member is changed by controlling the amount of current flowing the phase control region of the second SG-DFB structure member, the peak of the reflection spectrum matched at the first SG-DFB structure member and the second SG-DFB structure member is matched with the $-1^{th}$ order reflection peak by moving the reflection spectrum, i.e., an oscillation spectrum, of the second SG-DFB structure member.

That is, if the laser diode is operated when the operating wavelength is changed in response to the change of the wavelength corresponding to the reflection peak, the laser having a wavelength with $-1^{th}$ reflection peak value becomes to oscillate.

At this time, if the reflective index of the phase control regions of the second SG-DFB structure member is changed continuously, the operating wavelength is changed in response to the change by continuously varying the corresponding reflection peak. If the reflective index of the one region of the phase control region is fixed by this method, and the reflective index of the other region of the phase control region is changed, the oscillation wavelength of the laser diode in accordance with the preferred embodiment of the present invention are varied incontinuously.

The distance between the tuned oscillation wavelengths is changed by the distance between the reflection spectrum peaks of the structure member having no change of the reflective index, here, the structure member is the first SG-DFB structure member. The reflective index can be controlled by changing the amount of current flowing to the n type electrode 39 in the first or the second phase control electrodes 38A, 38B.

Continuously, as referring to Fig. 5, when the reflective indexes of each of the structure members are changed to have the same in size by varying the amount of current flowing into the phase control region 35A of the first SG-DFB structure member and the phase control region 35B of the second SG-DFB structure member, the reflection spectrums of the two structure members are moved identically.

In this result, the wavelength of the corresponding reflection peak is changed by the movement of the reflection spectrum. Accordingly, the oscillating wavelength is continuously changed based on the change of the amount of current flowing into the phase control regions 35A, 35B of each of the structure members.

And also, it is possible to continuously tune the wavelength by applying the offset current to the phase control region of one side of structure member; changing the reflective index of the phase control region based on the applied result; changing the corresponding wavelength; and changing amount of current flowing into the phase control region 35A of the first SG-DFB structure member and the phase control region 35B of the second SG-DFB structure member. In this case, the other wavelength except the Bragg wavelength can be continuously changed by flowing the current asymmetrically at the phase control regions 35A, 35B of the two structure members.

For example, the reflection spectrums of the first SG-DFB structure member and the second SG-DFB structure member are matched at the -1th order by changing the reflective index of phase control region 35B of the second SG-DFB structure member by applying the offset current through the phase control electrode of the second SB-DFB structure (as shown in Fig. 5B).

Fig. 6 is a graph showing the change of oscillation wavelength when the reflective index of one side of the structure members is changed through a computer simulation. Fig. 6 shows one result of computer simulation to identify that the wavelength tunable laser diode suggested in the present invention as described above has the wavelength tunable characteristics by using the operator split-step time-domain model proposed in an article by B. S. Kim, Y. Chung, J. S. Lee, entitled "An efficient split-step time-domain dynamic modeling of DFB/DBR laser diodes", *IEEE J. of Quantum Electronics,* Vol. 36, No. 7, PP. 787-794, Jul. 2000. The model is known as an effective model to analyze the DFB-DBR laser diode.

The graph shown in Fig. 6 illustrates the result when the periods of the first region and the second region of the sampled-gratings 34A, 34B are assumed at 202.5 mm and 192 mm, respectively and the overall length of the device is assumed at 1,183 mm by taking the number of the sampled-gratings in each of the regions as 3.

Referring to Fig. 6, the oscillation wavelength of the laser diode is oscillated by a predetermined space of 2000 GHz, i.e., 1.6 nm, in response to the change of the reflective index of the phase control region 38B of the second SG-DFB structure member due to the amount of current flowing into the phase control region 38B of the second SG-DFB structure member, it can be identified by the above described Eq. (2) that the space of the reflection peaks of the first region is equal to the predetermined space. In this result, it can be easily predicted that the structure of the SG-DFB laser diode disclosed in the present invention is operated well.

And also, in accordance to the requirement to the wavelength tunable SG-DFB laser diode proposed by the present invention, an optical communication device can be implemented by integrating an optical modulator or a semiconductor optical amplifier together with the tunable SG-DFB laser diode on a semiconductor substrate. That is, by applying the signal by integrating the electro-absorber region on the output portion of the proposed SG-DFB laser diode, the laser diode is utilized as a long distance communication optical source by minimizing the effect for the frequency chirping. In addition to, the laser diode can be utilized as an optical communication device having a high output power by integrating the optical amplifier.

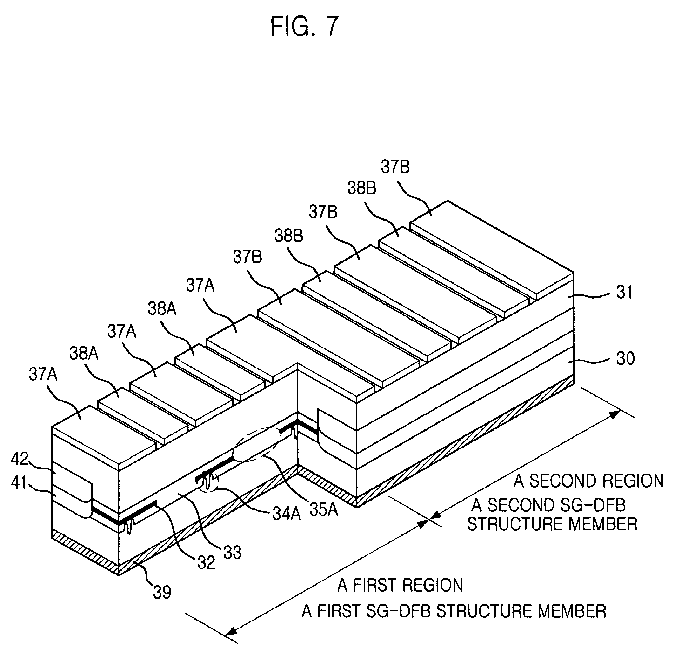

Fig. 7 is a perspective view illustrating the widely tunable sampled-grating distributed feedback laser diode shown in Fig. 3. The reference numerals of the major parts shown in Fig. 7 are similar to those shown in Fig. 3 and the reference numeral 40 represents an n type InP current cladding layer and the reference numeral 41 represents a p type InP current cladding layer.

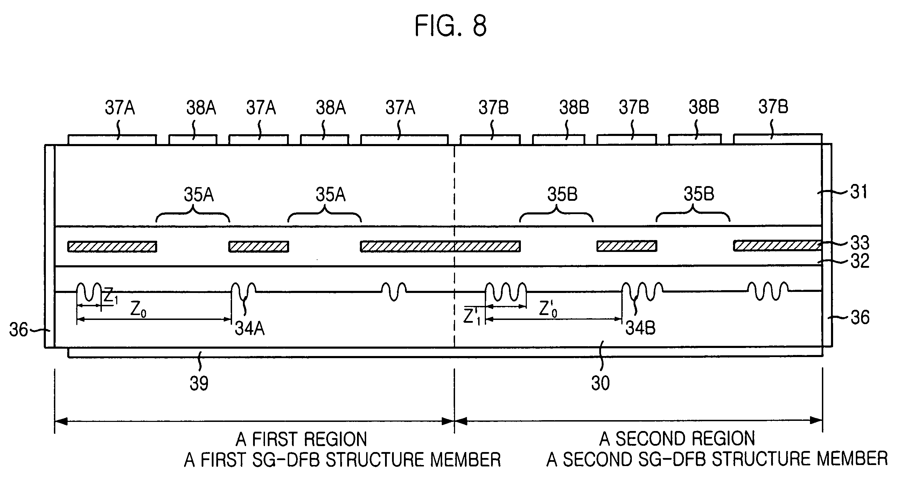

Fig. 8 is a cross-sectional view describing the widely tunable sampled-grating distributed feedback laser diode in accordance a second preferred embodiment of the present invention.

In the SG-DFB laser diode, as shown in Fig. 8, the Bragg wavelength of the first SG-DFB and the Bragg wavelength of the second SG-DFB are formed different from each other by forming the periods (Z1, Z'1) of the diffraction grating of the first SG-DFB and the second SG-DFB structure members in the overall structure. The operation principle of the SG-DFB laser diode shown in Fig. 8 is similar to that of the SG-DFB laser diode shown in Fig. 3.

The SG-DFB laser diode of the present invention has a high output optical efficiency in comparison with a conventional wavelength tunable laser provided with Bragg reflection ends at the both ends of the gain region for the wavelength tuning as a structure capable of connecting an optical fiber directly without losing the optical wave generated at the gain region.

And also, the SG-DFB laser diode of the present invention can control a broad band wavelength with a simple circuit construction in comparison with a conventional wavelength tunable laser diode since it can vary the wavelength in continuous/incontinuous by the change of current of the each region of the phase control regions.

Further, the present invention can be manufactured by the manufacturing process of a conventional wavelength tunable laser diode without reinvesting a new equipment.

While the present invention has been described with respect to certain preferred embodiments, it will be apparent to those skilled in the art that various changes and modifications may be made without departing from the scope of the invention as defined in the following claims.

**Claims**

1. A tunable sampled-grating distributed feedback laser diode provided with a first gain region and a second gain region adjacent to each other, comprising:

   a first SG-DFB structure member formed thereon a first phase control region between first sampled-gratings and the first sampled-gratings having a first period formed on the first gain region; and
   a second SG-DFB structure member formed thereon a second phase control region between second sampled-gratings and the second sampled-gratings having a second period formed on the second gain region, wherein the tunable sampled-grating distributed feedback laser diode tunes the wavelength of laser generated in response to a reflection change of the first and the second phase control regions.

2. The tunable sampled-grating distributed feedback laser diode as recited in claim 1, wherein a period of the first sampled-grating is equal to that of the second sampled-grating.

3. The tunable sampled-grating distributed feedback laser diode as recited in claim 1, wherein reflection changes of the first phase control region and the second phase control region are obtained by changing the amount of current applied to the first phase control region and the second phase control region, respectively.

4. The tunable sampled-grating distributed feedback laser diode as recited in claim 1, wherein a wavelength of the oscillating laser is incontinuously changed by varying the reflective indexes of the first phase control region or the second phase control region.

5. The tunable sampled-grating distributed feedback laser diode as recited in claim 1, wherein a wavelength of the oscillating laser is continuously changed by varying the reflective indexes of the first phase control region and the second phase control region in the same size.

6. An optical communication device is **characterized in that** an optical modulator or a semiconductor optical amplifier together with the tunable sampled-grating distributed feedback laser diode is integrated into a semiconductor substrate,
  wherein the tunable sampled-grating distributed feedback laser diode provided with a first gain region and a second gain region adjacent to each other, includes:

    a first SG-DFB structure member formed thereon a first phase control region between first sampled-g ratings and the first sampled-gratings having a first period formed on the first gain region; and
    a second SG-DFB structure member formed thereon a second phase control region between second sampled-gratings and the second sampled-gratings having a second period formed on the second gain region, wherein the tunable sampled-grating distributed feedback laser diode tunes the wavelength of laser generated in response to a reflection change of the first and the second phase control regions.

7. A tunable sampled-grating distributed feedback laser diode for tuning a wavelength of an oscillating laser, comprising:

    a substrate provided with a first region and a second region adjacent to each other;
    a wave guide layer formed on the first region and the second region of the substrate;
    a multiple quantum well active layer formed in the wave guide layer by a predetermined distance for providing a plurality of phase control regions;
    a first sampled-grating region having a first period and the phase control region formed between the sampled-grating;
    a second sampled-grating region having a second period and the phase control region formed between the sampled-grating;
    a clad layer formed on the wave guide layer;
    a first phase control electrode formed on the clad layer of the first region for supplying a current to the phase control region of the first region;
    a second phase control electrode formed on the clad layer of the second region for supplying a current to the phase control-region of the second region;
    a first gain region electrode formed on the clad layer of the first region for supplying a current to the wave guide layer except the phase control region of the first region; and
    a second gain region electrode formed on the clad layer of the second region for supplying a current to the wave guide layer except the phase control region of the second region.

8. The tunable sampled-grating distributed feedback laser diode as recited in claim 7, wherein a period of the first sampled-grating and a period of the second sampled-grating are configured different from each other and periods of diffraction gratings of the first and the second sampled-gratings are constructed identically.

9. The tunable sampled-grating distributed feedback laser diode as recited in claim 7, wherein the substrate is an n type InP substrate, the wave guide layer is made of a material such as InGaAsP and the clad layer is a p type InP.

10. The tunable sampled-grating distributed feedback laser diode as recited in claim 7, wherein a wavelength of the oscillating laser is incontinuously changed by varying a reflective index of the phase control region of the first region or the phase control region of the second region.

11. The tunable sampled-grating distributed feedback laser diode as recited in claim 7, wherein a wavelength of the oscillating laser is continuously changed by simultaneously varying the reflective indexes of the phase control region of the first region and the phase control region of the second region.

12. An optical communication device is **characterized in that** an optical modulator or a semiconductor optical amplifier together with the tunable sampled-grating distributed feedback laser diode is integrated on a semiconductor substrate,

wherein the tunable sampled-grating distributed feedback laser diode includes:

a substrate provided with a first region and a second region adjacent to each other;
a wave guide layer formed on the first region and the second region of the substrate;
a multiple quantum well active layer formed in the wave guide layer by a predetermined distance for providing a plurality of phase control regions;
a first sampled-grating region having a first period and the phase control region formed between the sampled-grating;
a second sampled-grating region having a second period and the phase control region formed between the sampled-grating;
a clad layer formed on the wave guide layer;
a first phase control electrode formed on the clad layer of the first region for supplying a current to the phase control region of the first region;
a second phase control electrode formed on the clad layer of the second region for supplying a current to the phase control region of the second region;
a first gain region electrode formed on the clad layer of the first region for supplying a current to the wave guide layer except the phase control region of the first region; and
a second gain region electrode formed on the clad layer of the second region for supplying a current to the wave guide layer except the phase control region of the second region.

# FIG. 1A
# (PRIOR ART)

VERNIER CONTROL CIRCUIT ~17

OFFSET CONTROL CIRCUIT ~18

GAIN CONTROL CIRCUIT ~15

PHASE CONTROL CIRCUIT ~16

11  12  13  14

SG–DBR REGIONS  GAIN REGIONS  PHASE CONTROL REGIONS  SG–DBR REGIONS

FIG. 1B
(PRIOR ART)

FIG. 1C
(PRIOR ART)

FIG. 2A
(PRIOR ART)

Z

FIG. 2B
(PRIOR ART)

REFLECTIVITY

....

λ

## FIG. 3

A FIRST REGION
(A FIRST SG-DFB STRUCTURE MEMBER)

A SECOND REGION
(A SECOND SG-DFB STRUCTURE MEMBER)

EP 1 478 064 A1

FIG. 4A

Λ

FIG. 4B

REFLECTIVITY

$\lambda_B$

$\lambda$

# FIG. 5A

A FIRST REGION

REFLECTIVITY

-3  -2  -1  0  1  2  3

λ

A SECOND REGION

REFLECTIVITY

λ_B

λ

# FIG. 5B

A FIRST REGION

REFLECTIVITY

-3  -2  -1  0  1  2  3

λ

A SECOND REGION

REFLECTIVITY

λ

FIG. 5C

A FIRST REGION

A SECOND REGION

FIG. 6

FIG. 7

A SECOND REGION
A SECOND SG-DFB
STRUCTURE MEMBER

A FIRST REGION
A FIRST SG-DFB STRUCTURE MEMBER

# FIG. 8

37A  38A  37A  38A  37A    37B  38B  37B  38B  37B

35A      35A        35B      35B — 31

33
32

$Z_1$  $Z_0$  34A    $\overline{Z'_1}$  $Z'_0$  34B

36    36

39    30

A FIRST REGION | A SECOND REGION
A FIRST SG-DFB STRUCTURE MEMBER | A SECOND SG-DFB STRUCTURE MEMBER

EP 1 478 064 A1

European Patent
Office

**EUROPEAN SEARCH REPORT**

Application Number

EP 03 25 8261

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | GEERT MORTHIER, BART MOEYERSOON AND ROEL BAETS: "A lambda/4-shifted sampled or superstructure grating widely tunable twin-guide laser" IEEE PHOTONICS TECHNOLOGY LETTERS, vol. 13, no. 10, 10 October 2001 (2001-10-10), pages 1052-1054, XP002281381 * page 1052, right-hand column - page 1053, left-hand column; figure 1 * | 1-6 | H01S5/0625 H01S5/12 |
| Y | * page 1054, right-hand column * | 12 | |
| Y | ISHII H ET AL: "A TUNABLE DISTRIBUTED AMPLIFICATION DFB LASER DIODE (TDA-DFB-LD)" IEEE PHOTONICS TECHNOLOGY LETTERS, IEEE INC. NEW YORK, US, vol. 10, no. 1, 1998, pages 30-32, XP000737118 ISSN: 1041-1135 * abstract * * figure 1c * * page 30, left-hand column, line 23 - page 31, right-hand column, line 20 * * page 32, left-hand column, line 20 - right-hand column, line 1 * | 7-12 | |
| | | | TECHNICAL FIELDS SEARCHED (Int.Cl.7) H01S |
| Y | US 5 748 660 A (OUGIER CHRISTOPHE ET AL) 5 May 1998 (1998-05-05) * column 3, line 43 - line 56; figure 4 * * column 6, line 42 - line 57 * | 7-12 | |
| | -/-- | | |

The present search report has been drawn up for all claims

| Place of search | Date of completion of the search | Examiner |
|---|---|---|
| Munich | 25 June 2004 | Meacher, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

## EUROPEAN SEARCH REPORT

Application Number

EP 03 25 8261

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | MASON B ET AL: "DESIGN OF SAMPLED GRATING DBR LASERS WITH INTEGRATED SEMICONDUCTOR OPTICAL AMPLIFIERS" IEEE PHOTONICS TECHNOLOGY LETTERS, IEEE INC. NEW YORK, US, vol. 12, no. 7, July 2000 (2000-07), pages 762-764, XP000968665 ISSN: 1041-1135 * figure 1 * | 6,12 | |
| A | RYU S-W ET AL: "MONOLITHIC INTEGRATION OF A MULTIWAVELENGTH LASER ARRAY ASSOCIATED WITH ASYMMETRIC SAMPLED GRATING LASERS" IEEE JOURNAL OF SELECTED TOPICS IN QUANTUM ELECTRONICS, IEEE SERVICE CENTER, US, vol. 8, no. 6, November 2002 (2002-11), pages 1358-1365, XP001175366 ISSN: 1077-260X * figure 1 * | 1-12 | |
| A | SAN-LIANG LEE ET AL: "Design of DWDM laser arrays based on sampled grating DFB lasers" 2002 IEEE 18TH. INTERNATIONAL SEMICONDUCTOR LASER CONFERENCE. GARMISCH, GERMANY, SEPT. 29 - OKT. 3, 2002, IEEE INTERNATIONAL SEMICONDUCTOR LASER CONFERENCE, NEW YORK, NY: IEEE, US, vol. CONF. 18, 29 September 2002 (2002-09-29), pages 73-74, XP010609169 ISBN: 0-7803-7598-X * page 73; figure 1 * | 1-12 | TECHNICAL FIELDS SEARCHED (Int.Cl.7) |
| A | US 2002/181532 A1 (KIM JE HA ET AL) 5 December 2002 (2002-12-05) * abstract; figures 2A,3,4 * | 1-12 | |

The present search report has been drawn up for all claims

| Place of search | Date of completion of the search | Examiner |
|---|---|---|
| Munich | 25 June 2004 | Meacher, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 03 25 8261

This annex lists the patent family members relating to the patent documents cited in the above-mentioned European search report.
The members are as contained in the European Patent Office EDP file on
The European Patent Office is in no way liable for these particulars which are merely given for the purpose of information.

25-06-2004

| Patent document cited in search report | | Publication date | Patent family member(s) | | Publication date |
|---|---|---|---|---|---|
| US 5748660 | A | 05-05-1998 | FR<br>DE<br>GB | 2737353 A1<br>19629916 A1<br>2303739 A ,B | 31-01-1997<br>30-01-1997<br>26-02-1997 |
| US 2002181532 | A1 | 05-12-2002 | KR | 2002091635 A | 06-12-2002 |